# FASCICULE DE BREVET EUROPEEN

(11) **EP 0 471 830 B1**
(45) Date de publication et mention de la délivrance du brevet: **28.09.1994**
(21) Numéro de dépôt: 91906192.9
(22) Date de dépôt: 01.03.1991
(51) Int. Cl.: H01R 13/635

(54) **CONNECTEUR ELECTRIQUE POUR BANC DE TEST**
ELEKTRISCHER VERBINDER FÜR PRÜFSTAND
ELECTRICAL CONNECTOR FOR TEST RIG

(30) Priorité: 02.03.1990 FR 9002669
(43) Date de publication de la demande: 26.02.1992
(73) Titulaire: FRAMATOME CONNECTORS FRANCE, 78000 Versailles (FR)
(72) Inventeur: LEBRIS, Henri, F-92160 Antony (FR); SANGLEBOEUF, Patrick, F-72000 Le Mans (FR)
(74) Mandataire: Fort, Jacques
(86) Numéro de dépôt international: FR9100168
(87) Numéro de publication internationale: WO9113477

(56) Documents cités:
- EP-A- 0 273 194
- DE-A- 2 937 035
- DE-A- 3 411 101

## Description

La présente invention a pour objet un connecteur électrique, destiné à être temporairement raccordé à un autre connecteur et prévu à cet effet pour vérifier la continuité électrique d'ensembles ou de sous-ensembles et donc leur capacité à fonctionner. Elle trouve une application particulièrement importante dans l'industrie automobile ; en effet, pour faciliter les vérifications et les dépannages sur les véhicules, on munit de plus en plus ces derniers de connecteurs autorisant une vérification par simple détection de présence ou d'absence d'une tension sur leurs bornes de contact. Ces connecteurs sont par exemple portés par la planche de bord, ou un pare chocs équipé d'organes électriques ; ils peuvent être prévus sur des faisceaux câblés, etc...

On connaît déjà des connecteurs permettant de remplir de telles fonctions. Ils ont des inconvénients. En particulier, les bornes de contact des connecteurs de test actuels sont en général des bornes classiques, dont l'engagement et le dégagement dans des conditions souvent difficiles risquent d'endommager le connecteur testé. Le connecteur de test, maintenu sur le connecteur à tester par les moyens habituels de verrouillage du connecteur à tester, doit être arraché manuellement à la fin des vérifications, avec le risque d'une extraction en biais susceptible de fausser les contacts.

La présente invention vise à fournir un connecteur de test répondant mieux que ceux antérieurement connus aux exigences de la pratique, notamment en ce qu'il élimine la plupart des causes d'endommagement des connecteurs à tester.

Dans ce but, l'invention propose un connecteur de test comprenant un boîtier enfichable, muni de moyens propres de verrouillage sur un connecteur à tester, contenant une plaque isolante repoussée élastiquement vers une position avant et destinée à recevoir l'appui de la face avant du connecteur à tester et des tiges de contact électrique portées par ladite plaque et repoussées élastiquement vers une position où elles présentent une saillie déterminée par rapport à la plaque, lesdites tiges étant réparties au pas des contacts électriques du connecteur à tester.

Un tel connecteur comporte donc des moyens élastiques ayant une fonction d'éjection à la fin des vérifications, dès déverrouillage du boîtier, totalement distincts des moyens assurant la fonction de contact électrique. Cette dernière fonction est assurée par des tiges de contact en bout, qui ne pénètrent pas à l'intérieur des contacts du connecteur à tester et en conséquence s'appliquent aussi bien sur des contacts de type broche que sur des contacts de type douille. Le montage élastique des tiges permet de rattraper tous les écarts dimensionnels ou de positionnement des contacts du connecteur à tester et garantit une résistance électrique de contact faible.

L'invention sera mieux comprise à la lecture de la description qui suit d'un mode particulier de réalisation de l'invention, donné à titre d'exemple non limitatif. La description se réfère aux dessins qui l'accompagnent, dans lesquels :
- la figure 1 montre un connecteur de test accouplé à un connecteur à tester, en coupe suivant le plan I-I de la figure 3 ;
- la figure 2 montre les connecteurs assemblés, en coupe II-II de la figure 1 ;
- la figure 3 est une vue en coupe suivant la ligne III-III de la figure 1.

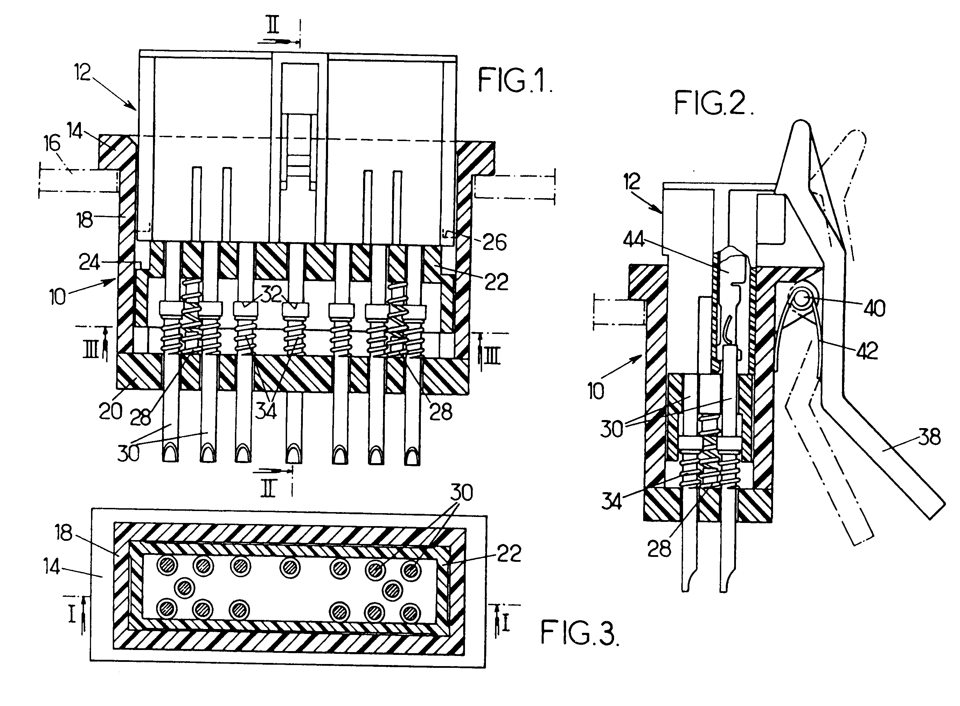

Le connecteur de test 10 montré en figure 1 à 3 est destiné à recevoir un connecteur 12 à tester. Dans le mode de réalisation illustré, le connecteur de test 10 est destiné à recevoir un connecteur rectangulaire, comportant des contacts répartis en deux rangées mais on pourrait tout aussi bien réaliser un connecteur de test destiné à d'autres types de connecteurs à tester.

Le connecteur 10 représenté est muni d'une bride 14 permettant de le fixer sur une paroi 16 mais ce mode de montage n'est nullement indispensable.

Le connecteur 10 comprend un boîtier en matériau isolant. Ce boîtier peut être constitué d'une seule pièce, par exemple en matière thermo-plastique moulée. Dans le mode de réalisation représenté, il se compose d'un corps 18 muni de la bride 14 et d'un fond 20 fixé, par exemple par des vis, sur le corps. Une plaque ou platine d'éjection 22 est montée dans le corps de façon à pouvoir coulisser, suivant l'axe du corps, entre une position rétractée où elle prend appui sur le fond 20 et une position de saillie maximum ; dans le cas d'un boîtier démontable, cette position peut être définie par appui d'un épaulement 24 qu'elle comporte sur un rebord interne 26 du corps 18. Des moyens élastiques repoussent la plaque 22 vers sa position de saillie maximum. Dans le mode de réalisation illustré, ils comprennent deux ressorts 28 comprimés entre le fond 20 et la plaque 22 et situés dans le plan médian du connecteur 10. Des pions emmanchés respectivement dans le fond 20 et la plaque 22 guident les extrémités des ressorts hélicoïdaux 28. Ces ressorts ont pour fonction d'éjecter le connecteur 12 lorsqu'il n'est plus retenu sur le connecteur 10 par des moyens de verrouillage, comme on le verra plus loin.

Le fond 28 du connecteur de test 10 porte des contacts 30 parallèles à l'axe du connecteur et présentant la même répartition que celle des contacts du connecteur 12 à tester. Ces contacts 30 comportent une partie avant en forme de tige de contact, destinée à s'appliquer contre les contacts du connecteur à tester 12. Ces tiges ont une section droite telle qu'elles viennent prendre un appui de butée contre les contacts du connecteur 12, que ces contacts soient de type lame, de type broche ou de type douille. La partie arrière de chaque contact 30 fait saillie hors du fond et a une forme permettant une liaison permanente, par exemple par soudage, à des fils provenant d'un banc de test.

Les tiges des contacts 30 sont montées à frottement doux dans des ouvertures respectives ménagées dans la plaque 22. Des moyens élastiques individuels repoussent chacun de ces contacts 30 vers une position où la tige présente une saillie maximum, définie par l'appui d'un épaulement 32 du contact contre la plaque 22. Dans le mode de réalisation montré en figures 1 et 2, ces moyens élastiques sont constitués par des ressorts hélicoïdaux individuels 34 comprimés entre le fond 20 et un renflement du contact.

Le connecteur de test 10 est avantageusement muni de moyens de verrouillage qui peuvent être conçus pour être aisément armables et désarmables, l'encombrement de ces moyens n'étant pas une sujétion. Les moyens de verrouillage peuvent être manuels ou commandés automatiquement.

Dans le mode de réalisation montré en figure 2, ces moyens de verrouillage comprennent un levier 38 tournant sur un axe 40 porté par une excroissance du corps 18 et pouvant se déplacer entre une position de verrouillage, où il est montré en traits pleins sur la figure 2, et une position de désarmement, en appui contre le corps 18 (en tirets sur la figure 2). Un ressort 42 sollicite le levier vers sa position de verrouillage, où un bec dont il est muni permet de retenir le connecteur à tester 12 en position totalement enfichée. La partie du levier munie du bec présente un pan oblique d'entrée, de façon à permettre l'insertion du connecteur à tester 12 jusqu'à sa position de plein engagement. Une palette terminale du levier 38, placée à l'opposé du bec, permet de désarmer aisément le levier.

Pour éviter une erreur d'orientation lors de l'insertion du connecteur à tester 12, le connecteur de test 10 sera généralement muni de moyens de détrompage, constitués par exemple par une nervure (non représentée) destinée à s'engager dans une rainure correspondante du connecteur à tester 12.

Un même connecteur de test 10 est susceptible de recevoir divers connecteurs à tester. En effet certaines des broches peuvent rester inutilisées lorsque le connecteur à tester a un nombre de contacts réduit. Un postiche peut même être placé dans le connecteur de test 18 en substitution d'une partie des contacts, pour éviter que le connecteur à tester ne prenne une position anormale.

La mise en oeuvre du connecteur de test ressort de la description qui précède. Lorsqu'un connecteur 12 est à tester, il est simplement inséré dans le connecteur 10. Au cours de l'insertion, le bec du levier 38 s'écarte pour livrer passage au connecteur. La face terminale du connecteur 12 vient en contact avec la plaque et commence à la refouler vers le bas, sans qu'aucun effort ne soit exercé sur les contacts du connecteur 12, dont un seul 44 est schématiquement montré en figure 2. Au fur et à mesure de la descente de la plaque 22 vers le fond 20, les tiges des contacts 30 prennent une position de plus en plus avancée par rapport à la plaque. Lorqu'ils arrivent en saillie par rapport à la plaque, ils viennent s'appuyer contre les contacts 44. Les ressorts 34 limitent la force d'appui exercée sur les contacts et évitent tout risque de déformation. Ces ressorts 34 peuvant être tarés pour exercer une force très inférieure à celle des ressorts d'éjection 28. Le connecteur 12 peut être relaché dès qu'il est immobilisé par le bec du levier 38. Du fait de la présence des ressorts 34 et de la forme en tige des contacts 30, la résistance électrique de jonction entre les contacts des connecteurs 10 et 12 est faible et le risque de jeu est évité.

Pour séparer le connecteur à tester 12 du connecteur 10, il suffit de désarmer manuellement le levier 38. Les ressorts d'éjection 28 chassent alors le connecteur 12. Il est important de noter que les ressorts 34 ne prennent pratiquement aucune part à l'éjection.

## Revendications

1. Connecteur électrique de test, destiné à être temporairement raccordé à un connecteur à tester pour vérifier la continuité électrique d'ensembles ou de sous-ensembles reliés à ce dernier connecteur, comprenant : un boîtier (18,20) enfichable, muni de moyens propres (38) de verrouillage mécanique sur le connecteur à tester ; une plaque isolante (22) contenue dans le boîtier, repoussée élastiquement vers une position avant déterminée par rapport au boîtier et destinée à recevoir l'appui de la face avant du connecteur à tester (12) ; et des tiges de contact électrique (30) portées par ladite plaque (22) et repoussées élastiquement par rapport à la plaque (22), vers une position de repos où elles présentent une saillie déterminée par rapport à la plaque, lesdites tiges étant réparties aux pas des contacts électriques du connecteur à tester.

2. Connecteur selon la revendication 1, caractérisé en ce que la plaque isolante (22) est repoussée par des moyens élastiques constitués par des ressorts d'éjection du connecteur à tester (28) interposés entre la plaque et le fond (20) du boîtier.

3. Connecteur selon la revendication 1 ou 2, caractérisé en ce que les tiges de contact électrique sont repoussées élastiquement par des ressorts individuels (34) comprimés entre un renflement (32) solidaire de la tige et le fond du boîtier.

4. Connecteur selon la revendication 1, 2 ou 3, caractérisé en ce que la position de saillie déterminée des tiges est définie par l'appui d'un épaulement à la base de la tige contre la plaque (22).

5. Connecteur selon la revendication 1, 2 ou 3, caractérisé en ce que la force repoussant élastiquement les tiges est très inférieure à la force repoussant élastiquement la plaque isolante vers sa position avant.

## Patentansprüche

1. Elektrischer Verbinder für Prüfzwecke, dazu bestimmt, vorübergehend an einen zu prüfenden Verbinder angeschlossen zu werden, um den Stromfluß von an diesen Verbinder angeschlossenen Einheiten und Untereinheiten zu prüfen, umfassend: ein einsteckbares Gehäuse (18,20), das mit eigenen Vorrichtungen (38) zur mechanischen Verriegelung an dem zu testenden Verbinder ausgestattet ist; eine in dem Gehäuse enthaltene Isolierplatte (22), die elastisch in Richtung auf eine bestimmte vordere Stellung bezüglich dem Gehäuse gedrückt wird und dazu vorgesehen ist, die Auflage der Vorderseite des zu prüfenden Verbinders (12) aufzunehmen; und von der besagten Platte (22) getragene und elastisch bezüglich der Platte (22) in eine Ruhestellung gedrückte Elektrokontaktstäbe (30), in der sie in einem bestimmten Abstand gegenüber der Platte vorstehen, wobei diese Stäbe in dem gleichen Abstand wie die elektrischen Kontakte des zu prüfenden Verbinders verteilt sind.

2. Verbinder nach Anspruch 1, dadurch gekennzeichnet, daß die Isolierplatte (22) durch elastische Vorrichtungen weggedrückt wird, die aus Auswurffedern des zu prüfenden Verbinders bestehen, die zwischen der Platte und dem Boden (20) des Gehäuses angeordnet sind.

3. Verbinder nach Anspruch 1 oder 2, dadurch gekennzeichnet, daß die Elektrokontaktstäbee mittels eigener Federn (34), die zwischen einer mit dem Stab fest verbundenen Verdickung (32) und dem Boden des Gehäuses zusammengedrückt werden, elastisch weggedrückt werden.

4. Verbinder nach Anspruch 1, 2 oder 3, dadurch gekennzeichnet, daß die bestimmte, herausragende Stellung der Stäbe durch das Anliegen eines erhöhten Randes am Ansatz des Stabs an die Platte (22) bestimmt ist.

5. Verbinder nach Anspruch 1, 2 oder 3, dadurch gekennzeichnet, daß die Kraft, welche die Stäbe elastisch wegdrückt, erheblich geringer ist als die Kraft, welche die Isolierplatte in ihre vordere Stellung drückt.

## Claims

1. Electric test connector, for temporary connection to a connector to be tested for checking the electric continuity of units or sub-units connected to the latter named connector, comprising: a pluggable casing (18,20) provided with its own locking means (38) for mechanical locking on the connector to be tested; an insulating plate (22) contained within the casing, resiliently biased toward a forward position which is predetermined with respect to the casing and arranged for abutting connection with the front face of the connector to be tested (12); and electric contact pins (30) carried by said plate (22) and resiliently biased with respect to the plate (22) toward a rest position where they have a predetermined amount of projection with respect to the plate, said pins being distributed at the spacing of the electrical contacts of the connector to be tested.

2. Connector according to claim 1, characterized in that the insulating plate (22) is biased by resilient means constituted by springs for ejecting the connector to be tested, located between the plate and the bottom wall (20) of the casing.

3. Connector according to claim 1 or 2, characterized in that the electric contact pins are resiliently biased by individual springs (34) each compressed between a bulge (32) fast with the pin and the bottom wall of the casing.

4. Connector according to claim 1, 2 or 3, characterized in that the predetermined amount of projection of the pins is defined by abutment of a shoulder at the foot of the pin against the plate (22).

5. Connector according to claim 1, 2 or 3, characterized in that the force which resiliently biases the pins is much lower than the force which resiliently biases the insulating plate toward its forward position.
